(19) **Europäisches Patentamt**
**European Patent Office**
**Office européen des brevets**

(11) **EP 1 564 562 B1**

(12) **EUROPÄISCHE PATENTSCHRIFT**

(45) Veröffentlichungstag und Bekanntmachung des Hinweises auf die Patenterteilung:
**09.04.2008 Patentblatt 2008/15**

(51) Int Cl.:
***G01R 33/3815*** *(2006.01)*

(21) Anmeldenummer: **05002878.6**

(22) Anmeldetag: **11.02.2005**

(54) **Hybrid-Magnetanordnung**

Hybrid magnet assembly

Dispositif magnétique hybride

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **14.02.2004 DE 102004007291**

(43) Veröffentlichungstag der Anmeldung:
**17.08.2005 Patentblatt 2005/33**

(73) Patentinhaber: **Bruker BioSpin GmbH**
**76287 Rheinstetten (DE)**

(72) Erfinder: **Westphal, Michael, Dr.**
**76877 Offenbach (DE)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 1 229 340     DE-A1- 10 202 372**
**US-A- 4 931 759     US-A- 6 084 497**

- **PATENT ABSTRACTS OF JAPAN Bd. 2000, Nr. 26, 1. Juli 2002 (2002-07-01) & JP 2001 242231 A (JEOL LTD), 7. September 2001 (2001-09-07)**

EP 1 564 562 B1

**Beschreibung**

Die Erfindung betrifft eine koaxiale Magnetanordnung zur Erzeugung eines längs einer z-Achse verlaufenden Magnetfelds in einem Untersuchungsvolumen um z=0, das geeignet ist zur Messung magnetischer Resonanz, mit mindestens einer oder mit mehreren radial ineinander geschachtelten supraleitenden Solenoidspulen, die rotationssymmetrisch zur z-Achse (5) angeordnet sind und eine maximale axiale Ausdehnung $2 \cdot z_1$ aufweise, wobei die Solenoidspulen (1) auf Formkörpern aufgewickelt sind, die keine axialen Notches aufweisen, wobei die Windungen der mindestens einen Solenoidspule in einem radialen Bereich um die z-Achse der Magnetanordnung zwischen r1 und r2 mit r1 < r2 angeordnet und von weiteren, Magnetfeld erzeugenden Strukturen umgeben sind, die rotationssymmetrisch bezüglich der z-Achse (5) angeordnet sind, und die sich ausgehend von einem Radius r3, mit r3 > r2, radial nach außen erstrecken, wobei die Solenoidspule und die weiteren rotationssymmetrischen, Magnetfeld erzeugenden Strukturen im Untersuchungsvolumen konstruktionsbedingt ein Magnetfeld erzeugen, das mindestens einen inhomogenen Anteil $h_n z^n$ mit n > 2 aufweist, dessen Beitrag zur Gesamtfeldstärke auf der z-Achse um z = 0 mit der n-ten Potenz von z variiert und wobei eine Feldformvorrichtung aus magnetischem Material in einem radialen Bereich r5 < r1 vorgesehen ist, die den inhomogenen Anteil $h_n z^n$ kompensiert.

Das Magnetfeld h(z) als Funktion der Koordinate z auf der z-Achse eines solchen Magnetsystems lässt sich allgemein darstellen als:

$$h(z) = h_0 + h_1 z + h_2 z^2 + h_3 z^3 + h_4 z^4 + h_5 z^5 + h_6 z^6 + \ldots$$

Der Term $h_0$ stellt dabei das erwünschte ortsunabhängige und damit homogene Magnetfeld dar und sei hier und im Folgenden stets als positiv anzunehmen. Die weiteren Termen mit den St6n!oeniz!enten $h_1$, $h_2$,... beschreiben Veränderungen der Magnetfeldstärke mit der Ortskoordinate z und sind bei Magneten für Anwendungen in NMR-, MRI-, oder ICR-Apparaturen unerwünscht. Durch einen spiegelsymmetrischen Aufbau bezüglich einer Mittelebene lassen sich sämtliche Terme mit ungeraden Indizes theoretisch unterdrücken. Darüber hinaus ist es erstrebenswert, die Form der Magnetanordnung so zu wählen, dass die Störkoeffizienten mit geradzahligen indizes, insbesondere solche mit Meinen Indizes, systematisch verschwinden. Bei einer geeigneten Magnetanordnung kann sich der Ausdruck für das Magnetfeld h(z) vereinfachen, so dass

$$h(z) = h_0 + h_8 z^8 + \text{Terme höherer Ordnung.}$$

In diesem Fall wird dem homogenen Magnetfeld $h_0$ eine Feldstörung in Form einer Parabel achter Ordnung überlagert. Diese Störung nimmt bei hinreichend kleinen Werten von z beliebig kleine Werte an. Bei einer solchen Magnetanordnung gibt es eine charakteristische Strecke $z_0$, bei der die Störgröße $h_8 z_0^8$ einen vorgegebenen, für die jeweilige Anordnung noch tolerierbaren Maximalwert dhmax annimmt, der bei MRI-Apparaturen beispielsweise 1 ppm (part per million) bezogen auf den Wert $B_0$ beträgt. Bei rotationssymmetrischen Magnet anordnungen dieser Art ist das Magnetfeld h(z) nicht nur entlang der z-Achse in dem Bereich $-z_0 < z < z_0$ innerhalb der genannten Grenze theoretisch homogen, sondern darüber hinaus Innerhalb eines näherungsweise kugelförmigen Bereichs um das Symmetriezentrum mit dem Radius $z_0$. Dieser Bereich wird als Untersuchungsvolumen der Magnetanordnung bezeichnet. Je größer das Untersuchungsvolumen relativ zum Innendurchmesser der felderzeugenden Teile der Magnetanordnung gewünscht ist, desto größer hat in der Regel die Ordnung der Magnetanordnung zu sein.

Zur Erzeugung stärkerer Magnetfelder werden bevorzugt gekühlte Wicklungen aus Supraleiterdraht verwendet. Die einfachste geometrische Form einer Magnetwicklung ist eine Solenoidspule. Solenoidspulen sind jedoch zur Erzeugung homogener Magnetfelder ungeeignet, weil es bei einer derart einfachen Geometrie bislang nicht möglich ist, die Störkoeffizienten $h_2$, $h_4$, ... zu kompensieren. Daher ist es üblich, zur Erzeugung homogener Magnetfelder Wicklungen in Form einer Solenoidspule mit einer oder mehreren Aussparungen (notches) zu verwenden (DE 101 040 54). Mit einer solchen Aussparung ist es möglich, die Störkoeffizienten $h_2$ und $h_4$ zu kompensieren, so dass die beschriebene Anordnung eine Magnetanordnung sechster Ordnung darstellen kann. Ein wesentlicher Nachteil bei der Verwendung von Magnetwicklungen mit Aussparungen, die in der Praxis durch Ringe aus einem festen Material ausgefüllt sind, besteht darin, dass die angrenzenden Windungen aus Supraleiterdraht unter dem Einfluss der großen magnetischen Kräfte durch Reiben oder andere Relaxationen an der Grenzfläche vom supraleitenden in den normalleitenden Zustand übergehen können. Dieser als "Quench" bezeichnete Prozess führt in der Regel zu einer vollständigen Entladung des supraleitenden Magneten, wobei die im Magnetfeld gespeicherte Energie in Wärme umgewandelt wird. Dadurch kann es zu einer Überhitzung der normal leitenden Bereiche und im Extremfall zu einer Zerstörung der Magnetspule kommen.

Dies erschwert insbesondere die Erzeugung besonders hoher Magnetfelder bzw. verteuert die Magnetspule, da man gezwungen ist, die Stromstärke durch die Wicklungen zu begrenzen, um die magnetischen Kräfte, die auf den Supraleiterdraht an den Grenzflächen zu einer Aussparung wirken, klein zu halten. Die Magnetanordnung muss somit mit entsprechend mehr Windungen aus teurem Supraleiterdraht versehen werden, die gesamte Anordnung wird radial größer, was letztlich dazu führt, dass die maximal erreichbare magnetische Induktion im Untersuchungsvolumen begrenzt wird.

Aus der US 2002/140427 (entspricht EP 1 229 340) ist eine Magnetanordnung für hochauflösende Magnetresonanzspektroskopie bekannt, bei der neben einer unstrukturierten Solenoidspule ein zusätzliches Spulensystem vorgesehen ist, welches in der Magnetanordnung als Shim-Vorrichtung wirkt. Damit die aus dieser Magnetanordnung resultierenden Inhomogenitäten kompensiert werden können, sieht die bekannte Magnetanordnung eine Feldformvorrichtung vor, die einen radialen Abstand von der z-Achse von weniger als 80 Millimetern besitzt.

Im Bereich der NMR-Tomographie ist jedoch eine derartige Ausgestaltung im Allgemeinen nicht möglich, da es sich bei den zu untersuchenden Objekten meist um Menschen oder Tiere handelt, deren Einbringen in das Untersuchungsvolumen einen wesentlich größere freien Radius in der Raumtemperaturöffnung erfordert. Des Weiteren ist man bestrebt, Tomographie-Magneten möglichst kompakt zu konstruieren, um den Verbrauch an supraleitenden Draht für die Spulenwicklungen klein zu halten und somit Kosten zu sparen. Dies erschwert die Homogenisierung des Magnetfeldes im Untersuchungsvolumen.

Ein weiteres Problem von Magnetanordnungen ist, dass sie starke unerwünschte magnetische Steufelder in einem Umkreis von teilweise über 10 m um die Magnetanordnung herum erzeugen. In diesem Bereich können z.B. magnetische Datenspeicher gelöscht und magnetische Gegenstände von der Magnetanordnung angezogen und zu ihr hin katapultiert werden. Das Streufeld stellt somit eine Gefahrenzone dar.

Beispielsweise aus der US-B1-6,507,259 ist bekannt, oben beschriebene Magnetanordnungen mit zusätzlichen radial weiter außen liegenden supraleitenden Abschirmwicklungen zu versehen, in denen ein Strom in Gegenrichtung fließt. Diese Abschinmwicklungen erzeugen ein magnetisches Gegenfeld, wodurch das von der Magnetanordnung erzeugte Streufeld weitgehend unterdrückt werden kann (aktive Abschirmung). Dazu werden jedoch zusätzliche Windungen aus Supraleiterdraht sowie Tragekörper für die Abschirmwicklungen benötigt, wodurch die Magnetanordnung noch komplizierter, größer und teurer wird.

Eine andere Möglichkeit, das von einer Magnetanordnung erzeugte Streufeld zu unterdrücken, ist aus der US4,590,428 bekannt. Die dort beschriebene Spulenanordnung ist mit einem ferromagnetischen Zylindermantel umgeben, der einerseits zur Abschirmung äußerer SWrfdder dient und andererseits die Rückführung des Magnetflusses der Magnetanordnung bewirkt und somit das von der Spulenanordnung erzeugte magnetische Streufeld beschränkt (passive Abschirmung). Nachteilig an dieser Anordnung ist, dass die Masse der Magnetanordnung durch den voluminösen ferromagnetischen Zylindermantel sehr hoch ist und zudem einen ungewünhten Einfluss auf die Homogenität des Feldes hat.

Aufgabe der vorliegenden Erfindung ist es, eine kostengünstige, einfach und kompakt aufgebaute Magnetanordnung zur Erzeugung starker Magnetfelder für tomographische Anwendungen vorzuschlagen, bei der auf Aussparungen in der Solenoidspule verzichtet werden kann und wobei das von dieser Magnetanordnung erzeugte Magnetfeld in einem Untersuchungsvolumen eine große Homogenität aufweisen soll. Eine weitere Aufgabe der Erfindung besteht darin, das magnetische Streufeld der Magnetanordnung auf kostengünstige Weise zu minimieren.

Diese Aufgaben werden erfindungsgemäß dadurch gelöst, dass um das Untersuchungsvolumen ein Gradientenspulensystem in einem radialen Bereich zwischen r9 und r10 mit r10 > r9 vorgesehen ist, dass r5 < r10, dass

$$\frac{r5}{r1} < 0{,}7{,}$$ dass r5 ≥ 80 mm, dass das Aspektverhältnis $\frac{z1}{r1} < 5{,}$ und dass die mindestens eine Solenoidspule, die Feldformvorrichtung und die weiteren Magnetfeld erzeugenden Strukturen zusammen ein homogenes Feld im Untersuchungsvolumen erzeugen. Dabei bedeuten r1: innerer Radius der Solenoidspule(n), r5: radiale Position der Feldformvorrichtung, r9: innerer Radius des Gradientenspulensystems r10: äußerer Radius des Gradientenspulensystems, und z1: halbe axiale Ausdehnung der Solenoidspule.

Die Magnetfeld erzeugenden Strukturen sind derart strukturiert, dimensioniert und positioniert, dass in Zusammenwirkung mit der Feldformvorrichtung das Magnetfeld im Untersuchungsvolumen homogen ist. Auf diese Weise kann ein besonders einfacher Aufbau der Magnetfeld erzeugenden Strukturen, insbesondere mit einer unstrukturierten Solenoidspule, realisiert werden. Entscheidend für den Einfluss der Feldformvorrichtung 7 auf das im Untersuchungsvolumen herrschende Magnetfeld ist dabei das Verhältnis r5/r1 der radialen Anordnung der Feldformvorrichtung 7 zum Radius r1 der Solenoidspulen 1. Die Erfindung sieht vor, das Verhältnis r5/r1 so klein zu wählen, dass eine optimale Wirkung der Feldformvorrichtung auf das im Untersuchungsvolumen herrschende Magnetfeld erzielt wird. Dazu ist die Feldformvorrichtung erfindungsgemäß innerhalb des Außenradius r10 des Gradientensystems angeordnet. Im Gegensatz zu einer Unterbringung der Feldformvorrichtung innerhalb des Kryostaten, wird hierdurch ein großer Einfluss der Feldformvorrichtung auf das im Untersuchungsvolumen herrschende Magnetfeld gewährleistet, während gleichzeitig der Abstand r5 der Feldformvorrichtung zur z-Achse so groß gewählt ist, dass eine Magnetanordnung mit einer großen Raumtemperaturbohrung realisiert werden kann, um tomographische Aufnahmen an großen Objekten beziehungsweise Patienten durchzuführen. Zudem kann aufgrund der Feldformvorrichtung eine Verkürzung der Gesamtanordnung und damit eine kompakte Magnetanordnung realisiert werden. Im Gegensatz zu der bekannten Anordnung ergibt sich eine Magnet anordnung, die ein kleines Aspektverhältnis aufweist. Dies ist bei Magnetsystemen für den Einsatz in der Tomographie besonders wichtig, weil daraus wegen der großen Spulenradien eine erhebliche Material- und somit Kostenersparnis resultiert.

Insgesamt lässt sich eine derartige vorteilhafte Magnetanordung erstmals durch die Kombination der oben beschriebenen radialen Anordnungen der Feldformvorrichtung gegenüber dem Gradientensystems und der Anordnung der Magnet, feld erzeugenden Strukturen gegenüber der Solenoidspule sowie durch das Zusammenwirken der genannten Komponenten realisieren.

In einer bevorzugten Ausführungsform der Erfindung ist eine Feldformvorrichtung in einem radialen Bereich r5 < r9 angeordnet. Die Feldformvorrichtung befindet sich demnach näher an der z-Achse des Magnetsystems als das Gradientensystem. So nah an der z-Achse ist die Effizienz der Feldformvorrichtung für die Kompensation der inhomogenen Feldanteile $h_n \cdot z^n$ des Magnetspulensystems besonders groß. So kann beispielsweise die Anzahl der Magnetfeld erzeugenden Strukturen klein und einfach gehalten werden.

Die Feldformvorrichtung umfasst vorzugsweise mindestens 10 ringförmig angeordnete Elementgruppen, wobei jede Elementgruppe mindestens sechs, vorzugsweise mindestens 12 in Umfangsrichtung auf dem jeweiligen Ringumfang verteilte Einzelelemente aufweist. Somit wird eine genaue Feinabstimmung der Homogenität des Magnetfelds gewährleistet.

In einer Ausführungsform der Erfindung umfasst die Feldformvorrichtung eine zylinderförmig gebogene ferromagnetische Folie mit Ausstanzungen. Dies stellt eine besonders einfache und kostengünstige Möglichkeit dar, eine Feldformvorrichtung auszugestalten.

Bei einer bevorzugten Ausführungsform erzeugen die mindestens eine Solenoidspule, die Magnetfeld erzeugenden Strukturen und die Feldformvorrichtung im Betrieb im Untersuchungsvolumen zusammen ein Magnetfeldprofil, dessen z-Komponente in einer Reihenentwicklung entlang der z-Achse um das Symmetriezentrum des Untersuchungsvolumens $h = h_0 + h_2 z^2 + h_4 Z^4 + ... + h_{2n} Z^{2n}$ mit positivem Magnetfeldterm $h_0$ beträgt, wobei der gemeinsame Beitrag von der mindestens einen Solenoidspule und den weiteren Magnetfeld erzeugenden Strukturen zum Magnetfeldterm der 2. Ordnung positiv und zum Magnetfeldterm der 4. Ordnung negativ ist, während der Beitrag der Feldformvorrichtung zum Magnetfeldterm der 2. Ordnung negativ und zum Magnetfeldterm der 4. Ordnung positiv ist. Auf diese Weise werden kostengünstige Magnetanordnungen mit besonders kleiner axialer Länge realisierbar. Außerdem wird für die Kompensierung der Magnetfeldterme mit niedrigen Ordnungen, beispielsweise zweiter bis achter oder zehnter Ordnung besonders wenig ferromagnetisches Material für die Feldformvorrichtung benötigt und ein besonders großes homogenes Volumen erzielt.

Als besonders vorteilhaft erweist es sich, wenn der mit (-1) multiplizierte Quotient aus den Magnetfeldtermen $h_2$ und $h_4$ mindestens gleich dem halben Quadrat des Radius r5 der Feldformvorrichtung ist.

Bei einer besonders bevorzugten Ausfuhrungsform der erfindungsgemäßen Magnetanordnung ist als weitere Magnetfeld erzeugende Struktur mindestens ein rotationssymmetrischer Magnetkörper aus einem ferromagnetischen Werkstoff vorgesehen, der sich über einen radialen Bereich zwischen r3 und r4 mit r3 < r4 erstreckt, wobei gilt: r2 < r3 < 1,3 r2 und r4 > 1,3 r3. Der mindestens eine rotationssymmetrische Magnetkörper ist derart strukturiert, dimensioniert und positioniert, dass das Magnetfeld im Untersuchungsvolumen homogenisiert und das magnetische Streufeld außerhalb der Magnetanordnung weitgehend unterdrückt ist. Dabei bedeuten r2: äußerer Radius der Solen"ptde(n), r3: innerer Radius des Magnetkörpers (bzw. der Magnetkörper) und r4: äußerer Radius des Magnetkörpers (bzw. der Magnetkörper).

Der bzw. die die Solenoidspule umgebende(n) Magnetkörper bewirken einerseits eine Homogenisierung des Magnetfeldes im Untersuchungsvolumen sowie andererseits eine Rückführung des von der Solenoidspule erzeugten magnetischen Flusses. Der bzw. die Magnetkörper sind dabei relativ achsnah zur Solenoidspule angeordnet (r3 < 1,3·r2)- Somit ist das von der Solenoidspule erzeugte Magnetfeld durch die Magnetkörper extrem gut beeinflussbar. Der Einfluss der Magnetkörper auf das Magnetfeld hängt insbesondere von der Strukturierung der Magnetkörper ab. Diese Strukturierung kann sowohl auf dem radial inneren als auch auf dem radial äußeren Bereich des Magnetkörpers erfolgen. Insbesondere durch die Position und die Formgebung des Magnet körpers in seinem radial inneren Bereich lassen sich die Inhomogenitäten des von der Solenoidspule erzeugten Magnetfelds kompensieren. Die Wahl des Außenradius r4 des Magnetkörpers hat vorwiegend Einfluss auf die räumliche Einschränkung des Magnetfelds, so dass das von der Solenoidspule erzeugte magnetische Streufeld bei geeigneter Wahl der Parameter auch ohne die Verwendung von Abschimspulen aus supraleitendem Material reduziert werden kann. Durch die Verwendung einer einfachen Solenoidspule werden die magnetischen Kräfte auf die Spulenwicklungen besser beherrschbar und damit wird die Feldstärke, bei der der Magnet letztlich quencht deutlich erhöht Dadurch ist es möglich, die Stromstärke durch die Windungen und damit das erzeugte Magnetfeld zu erhöhen bzw. ein Magnetfeld mit vorbestimmter Feldstärke durch eine Spulenanordnung mit einer verringerten Anzahl an Windungen und erhöhtem Strom zu erzeugen und somit Kosten zu senken. Die erfindungsgemäße Magnetanordnung stellt somit eine Möglichkeit dar, unter Verwendung einer einfachen, wenig störungsanfälligen Solenoidspule ein hohes, homogenes Magnetfeld, das zur Messung magnetischer Resonanzen geeignet ist, zu erzeugen. Darüber hinaus kann das magnetische Streufeld außerhalb der Magnetanordnung weitgehend unterdrückt werden.

In einer bevorzugten Ausführungsform der Magnetanordnung sind genau zwei Magnetkörper vorgesehen, die insbesondere als Kreisringe mit rechteckigem Schnittprofil ausgeführt und symmetrisch zu einer Mittelebene quer zur z-Achse der Magnetanordnung angeordnet sind. Damit ergibt sich eine besonders einfache Konfiguration der Magnetanordnung, welche geeignet ist, ohne Berücksichtigung der Feldformvorrichtung einen positiven Magnetfeldterm $h_2/h_0$ und einen negativen Magnetfeldterm $h_4/h_0$ zu erzeugen. Die beiden Magnetkörper sind vorzugsweise nahe den axialen Enden angeordnet. Auf diese Weise erzeugen einerseits die beiden Magnetkörper allein einen positiven Beitrag zu dem Magnetfeldterm $h_2/h_0$.

Andererseits verursachen mechanische Toleranzen an den Grenzflächen der Magnetkörper oder Inhomogenitäten im Werkstoff nur in geringem Maße Störungen der Homogenität des Magnetfeldes im Untersuchungsvolumen.

Die Magnetkörper sind vorzugsweise aus weichmagnetischem Material, insbesondere aus Eisen oder magnetischem Stahl aufgebaut. Ein derartiges Magnetsystem erzeugt im entladenen Zustand kein durch Remanenzeffekte verursachtes Streufeld. Speziell Eisen oder magnetischer Stahl stellen zudem kostengünstige weichmagnetische Werkstoffe dar.

In einer weiteren Ausführungsform wird r4 größer als 1,5·r3 gewählt. Durch die entsprechende Mindestdicke der Magnetkörper wird gewährleistet, dass der magnetisch Fluss radial außerhalb der Magnetspule weitgehend innerhalb der Magnetkörper geführt wird, wodurch die Ausdehnung des magnetischen Streufeldes der Anordnung, wie gewünscht, gering bleibt.

In einer weiteren Ausführungsform wird r4 kleiner als 3 - r3 gewählt Dies unterstützt die Ausbildung einer relativ großen magnetischen Induktion innerhalb der/ des Magnetkörper(s) und führt infolgedessen zu einer relativ großen magnetischen Polarisation der/ des Magnetkörper(s). Deshalb benötigt man für die Erzeugung optimaler Magnetfeldterme $h_2/h_0$ und $h_4/h_0$ der Magnetanordnung ohne die Berücksichtigung der Feldformvorrichtung weniger Material für die/ den Feldformkörper und erhält so eine kompakte und kostengünstige Magnetanordnung.

In einer darüber hinaus bevorzugten Ausführungsform der Erfindung wird r4 so gewählt, dass im Betrieb der Magnetanordnung der Betrag der magnetischen Induktion B im Magnetkörper in einem radialen Bereich zwischen r3 und 1,05·r3 mindestens gleich dem Betrag der Sättigungspolarisation $M_s$ des ferromagnetischen Werkstoffs ist. Die Ausnutzung der maximalen Polarisation der Magnetkörper (Sättigungspolarisation $M_s$) insbesondere im radial inneren Bereich der Magnetkörpers hat zur Folge, dass zur Erzeugung optimaler Magnetfeldterme $h_2/h_0$ und $h_4/h_0$ der Magnetanordnung ohne Berücksichtigung der Feldformvorrichtung noch weniger Material für die Magnetkörper benötigt wird und sich somit eine besonders kompakte und kostengünstige Anordnung ergibt

In einer bevorzugten Ausführungsform werden die Magnetkörper im Betrieb gekühlt und vorzugsweise auf derselben kryogenen Temperatur gehalten wie die supraleitende(n) Solenoidspule(n). Eine thermische Abschirmung der Magnetkörper zu der (den) Solenoidspule(n) entfällt somit.

Der (die) Magnetkörper sind vorzugsweise starr mit einem Trägerkörper der Solenoidspule(n) verbunden, so dass trotz Auftreten großer magnetischer Kräfte keine Bewegung zwischen den einzelnen Bauteilen stattfinden kann.

Es kann vorteilhaft sein, wenn zusätzliche Magnetkörper an den axialen Enden der Solenoidspule in einem radialen Bereich zwischen r1 und r3 vorgesehen sind. Hierdurch werden die Kräfte innerhalb der Solenoidspule verringert. Zudem kann bei einer solchen Ausführungsform eine Spule mit reduzierter axialer Ausdehnung $2z_1$ verwendet werden, was eine zusätzliche Einsparung an supraleitenden Draht und somit eine Kostenersparnis zur Folge hat.

Die Magnetkörper und die zusätzlichen Magnetkörper können zusammen einstückig ausgebildet sein, um die Anzahl der einzubauenden Magnetkörper klein zu halten.

In einer besonders bevorzugten Ausführungsform der Magnetanordnung sind radial außerhalb des (der) Magnetkörper(s) oder in einem radialen Bereich r6 ≥0,9 r4 im äußeren Randbereich des (der) Magnetkörper(s) weitere Wicklungen aus supraleitendem Draht vorgesehen. Damit kann die Form des magnetischen Streufelds verbessert und außerdem eine Bündelung des magnetischen Flusses im Magnetkörper erreicht werden. Dadurch wird vorteilhafterweise eine größere Magnetisierung des (der) Magnetkörper(s) bewirkt, so dass Magnetkörper mit einem kleineren Volumen für den Aufbau der Magnetanordnung verwendet werden können. Die weiteren Wicklungen wirken hierbei wie eine aktive Abschirmung, benötigen aber aufgrund der magnetisierten Magnetkörper wesentlich geringere Ströme (Amperewindungen) als dies bei aktiven Abschirmungen aus dem Stand der Technik der Fall ist.

Vorzugsweise sind die weiteren Wicklungen zumindest im Betrieb supraleitend kurz geschlossen, beispielsweise bereits vor dem Laden der Magnetspule. Als Folge dessen laden sich die Wicklungen beim Laden der Solenoidspule und beim damit verbundenen Aufmagnetisieren des Magnetkörpers induktiv auf. Da der magnetische Fluss durch die weiteren Wicklungen konstant bleibt, stellen sich automatisch solche Ströme ein, die das magnetische Streufeld der Magnet anordnung minimieren. Auch während des Ladens oder Entladens der Magnetanordnung bleibt deshalb die Ausdehnung des magnetischen Streufeldes trotz der nichtlinearen Magnettsierungskennlinie der Magnetkörper gering.

Vorteilhaft ist es, wenn der (die) Magnetkörper als Tragekörper für die weiteren Wicklungen dient (dienen). Somit werden keine zusätzlid1en Tragekörper benötigt.

In einer besonders bevorzugten Aus%hrungsform umfassen die weiteren Wicklungen lediglich ein bis zehn Lagen von supraleitendem Draht. Es werden demnach nur geringe Mengen an supraleitenden Draht für die Wicklungen benötigt, so dass der Aufwand verglichen mit bekannten Abschirmvorrichtungen vergleichsweise gering ist.

In einer weiteren Ausführungsform der Erfindung umfassen die weiteren Wicklungen mehrere axial voneinander beabstandete Teilwicklungen, die jeweils für sich supraleitend kurzserießbar sind. Da nun die magnetischen Flüsse durch mehrere supraleitende Kreise konstant gehalten werden können, ist es möglich, eine örtlich angepasste und somit präzisere Abschirmung des magnetischen Streufelds vorzunehmen.

In einer weiteren Ausführungsform sind die weiteren Wicklungen mit der (bzw. den) Solenoidspule(n) supraleitend in Reihe geschaltet oder schaltbar. Die Wicklungen können somit vom Netzgerät der Solenoidspule mitgeladen werden.

In einer weiteren Ausführungsform der erfindungsgemäßen Magnetanordnung sind die weiteren Wicklungen ständig mit der (bzw. den) Solenoidspule(n) elektrisch verbunden. Durch die weiteren Wicklungen fließt dann der gleiche Strom wie durch die Solenoidspule. Vorteilhaft daran ist, dass lediglich ein Netz gerät sowohl zum Laden der Solenoidspule als auch zum Laden der weiteren Wicklungen benötigt wird.

In einer weiteren Ausführungsform sind die weiteren Wicklungen und die Solenoidspule (n) elektrisch voneinander isoliert. Die Ströme durch die weiteren Wicklungen sind dann unabhängig vom Strom durch die Solenoidspule und können, falls gewünscht, entsprechend Mein gewählt werden. Dies ermöglicht die Verwendung von dünneren und somit preisgünstigeren supraleitenden Drähten für die Wicklungen.

Bei einem Verfahren zum Betrieb einer erfindungsgemäßen Magnetanordnung, werden die weiteren Wicklungen gezielt auf einen gewünschten Betriebsstromwert geladen. Dies ermöglicht eine individuelle Anpassung des magnetischen Streubelds.

Bei einer besonders bevorzugten Variante des Verfahrens werden oder sind vor dem Beladen der Solenoidspule (n) mit ihrem vorgesehenen Betriebtsstrom die weiteren Wicklungen supraleitend kurzgeschlossen und frieren dadurch (jeweils) ihren magnetischen Fluss ein. So können beim Laden der Solenoidspule in den kurzgeschlossenen Windungen stets genau die Ströme Induziert werden, die das magnetische Streufeld minimieren.

In einer Abwandlung wird bereits ein (kleiner) positiver oder negativer Strom in die weiteren Wicklungen eingespeist und supraleitend kurzgeschlossen für den Fall, dass dies eine bessere Streufeldunterdrückung bewirkt.

Alternativ kann der Strom durch die weiteren Wicklungen (oder die Ströme im Fall mehrerer Kreise) unabhängig vom Hauptstrom auf einen berechneten oder per Messung bestimmten optimalen Wert eingestellt und eingefroren werden.

Bei einer alternativen Ausführungsform der erfindungsgemäßen Magnetanordnung umfassen die weiteren Magnetfeld erzeugenden Strukturen supraleitende Magnetspulen. Die Magnetanordnung kann somit radial kompakter ausgestaltet werden.

Eine Weiterbildung dieser Ausführungsform sieht vor, dass die Magnetfeld erzeugende Strukturen mindestens 2, vorzugsweise genau 2, axial voneinander beabstandete Magnetspulen umfassen. Damit ergibt sich eine besonders einfache Konfiguration der Magnetspulen.

Es ist vorteilhaft, wenn die mindestens eine Solenoidspule und die weiteren Magnetfeld erzeugenden Strukturen von einem supraleitenden aktiven Abschirmspulensystem umgeben sind. Diese aktive Abschirmung reduziert das Streufeld der Magnetanordnung, so dass im Labor mehr Platz für andere Anwendungen zur Verfügung steht

Vorzugsweise bildet die Magnetanordnung unter Berücksichtigung aller Magnet feld erzeugenden Strukturen mindestens eine Magnetanordnung 10. Ordnung mit einer Restwelligkeit < $10^{-5}$ im Untersuchungsvolumen.

Weitere Vorteile lassen sich erzielen, wenn die Feldformvorrichtung in einem radialen Bereich $r5 < 0,52$ $r1$ angeordnet ist In diesem Fall kommt man mit einer besonders kleinen Menge an magnetischen Elementen in der Feldformvorrichtung aus. Andererseits ist auch bei relativ kleinen Werten für $r5 < 0,52$ $-r1$ eine gute Homogenisierung des Magnetfeldes im Un1ersuchungsvohnnen möglich.

Die vorliegende Erfindung betrifft auch eine NMR-Apparatur, MRI-Apparatur oder ICR-Apparatur, die eine Magnetanordnung, wie vorhergehende beschrieben, umfaßt. NMR, MRI und ICR sind in der Medizin und in der Forschung weit verbreitete Verfahren, die homogene Magnetfelder verlangen. Daher besteht ein großer Bedarf, Apparaturen zur Durchführung dieser Verfahren zu verbessern und kostengünstig herzustellen. Dies wird durch die erfindungsgemäße Magnetanordnung realisiert.

Eine weitere Ausführungsform der erfindungsgemäßen Magnetanordnung sieht in einem radialen Bereich r8 > r4 und gegebenenfalls r8 > r6 eine ferromagnetische Ummantelung um die Magnetanordnung vor. Diese ferromagnetische Ummantelung kann sowohl als zusätzliche Abschirmung gegenüber äußeren Feldern als auch zur Unterdrückung des magnetischen Streufeldes dienen.

Vorzugsweise handelt es sich bei der erfindungsgemäßen Magnetanordnung um eine Hochfeldmagnetanordnung, wobei insbesondere die maximale axiale Komponente $B_z$ der magnetischen Induktion größer als 6T (Tesla) ist.

Die Vorteile der Erfindung kommen hierbei besonders gut zur Geltung, da die Erzeugung einer hinreichend guten Homogenität bei hohen Magnetfeldern mit einfachen konventionellen Magnetanordnungen besonders schwierig ist.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung findet Die gezeigten und beschriebenen Ausführungsformen sind nicht als abschließende Aufzählung zu verstehen, sondern haben vielmehr beispielhaften Charakter für die Schilderung der in den Ansprüchen definierten Erfindung.

Erzeugen:

**Fig. 1** eine schematische Darstellung einer Magnetspulenanordnung mit einer aktiven Abschirmung nach dem Stand der Technik

**Fig. 2** eine schematische Darstellung einer erfindungsgemäßen Ausführungsform einer Magnetanordnung umfassend eine Solenoidspule und einen strukturierten Magnetkörper;

**Fig. 3** eine schematische Darstellung einer erfindungsgemäßen Ausführungsform einer Magnetanordung umfassend eine Solenoidspule und vier Magnetkörper;

**Fig. 4** eine besonders bevorzugte Ausführungsform der erfindungsgemäßen Magnetanordnung umfassend eine Solenoidspule und zwei Magnetkörper und eine Feldformvorrichtung;

**Fig. 5a** ein Schaltbild einer Spulenanordnung mit einer Solenoidspule und mehreren kurzgeschlossenen weiteren Wicklungen:

**Fig. 5b** ein Schaltbild einer Spulenanordnung mit einer Solenoidspule und mehreren mit der Solenoidspule verbindbaren weiteren Wicklungen;

**Fig. 6** die Konturfinie r(z) konstanter relativer Abweichung der Magnetfeldstärke der Magnetanordnung aus Fig.4;

**Fig. 7a** eine schematische Darstellung einer erfindungsgemäßen Ausfuhrungsform einer Magnetanordnung mit einer in einem Gradientensystem integrierten Feldformvorrichtung;

**Fig. 7b** eine schematische Darstellung einer erfindungsgemäßen Ausführungsform einer Magnetanordnung, wobei die Feldformvorrichtung radial innerhalb des Gradientensystems angeordnet mit

**Fig. 8** eine schematische Darstellung einer erfindungsgemäßen Ausführungsform einer Magnetanordnung mit supraleitenden Magnetspulen als weitere Magnetfeld erzeugenden Strukturen.

**Tab. 1** Ausführungsbeispiel einer erfindungsgemäßen Magnetanordnung mit Abmessungen, Stromdichten bzw. der magnetischen Polarisation der Komponenten

**Tab. 2** Feldstörungen $h_2 z_0^2$, $h_4 z_0^4$ ...., der Magnetanordnung nach Tabelle 1 ohne Feldformvorrichtung an einer axialen Position $z_0$ mit $z_0 = 0{,}05$ m, bezogen auf das von der Magnetanordnung bei $z = 0$ erzeugte Magnetfeld $H_0$

**Tab. 3** die mittleren axialen Positionen für die Befestigung von Plättchen auf einem zylindrischen Träger der Feldformvorrichtung der Magnetanordnung nach Tabelle 1;

**Tab. 4** die Belegung der Eisenplättchen der Feldformvorrichtung nach Tabelle 3; und

**Tab. 5** die theoretische Feldstörungen $h_2, h_4$ , ...., der Magnetanordnung nach Tabelle 1 mit Feldformvorrichtung nach den Tabellen 3 und 4.

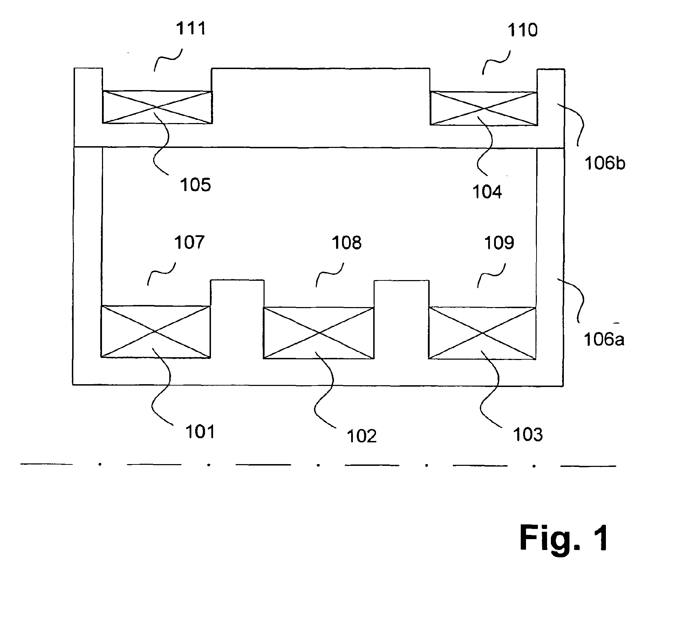

Fig. 1 zeigt die wesentlichen Bestandteile einer herkömmlichen aus US 6,507,259 B2 bekannten rotationssymmetrischen Magnetspulenanordnung. In einem zweiteiligen Tragekörper 106a, 106b sind Wickelkammern 107, 108, 109, 110, 111 eingearbeitet In diese Wickelkammern sind erste Magnetwicklungen 101, 102, 103 und zweite Magnetwicklungen 104, 105 jeweils aus Supraleiterdraht gewickelt. Die ersten Magnetwicklungen 101, 102, 103 dienen hauptsächlich der Erzeugung eines starken Magnetfelds in einem Untersuchungsvolumen, das beispielsweise bei Magnetspulenanordnungen für Magnetresonanzapparaturen das Symmetriezentrum der Magnetspulenanordnung umgibt. Die zweiten Magnetwicklungen 104, 105 dienen hauptsächlich der Minimierung des magnetischen Streufelds in der äußeren Umgebung der Magnetspulenanordnung mittels einer Rückführung des magnetischen Flusses (aktive Abschirmung). Die Richtung des elektrischen Stroms in den zweiten Magnetwicklungen 104, 105 ist deshalb gegenläufig zu der Richtung des elektrischen Stroms in den ersten Magnetwicklungen 101, 102, 103.

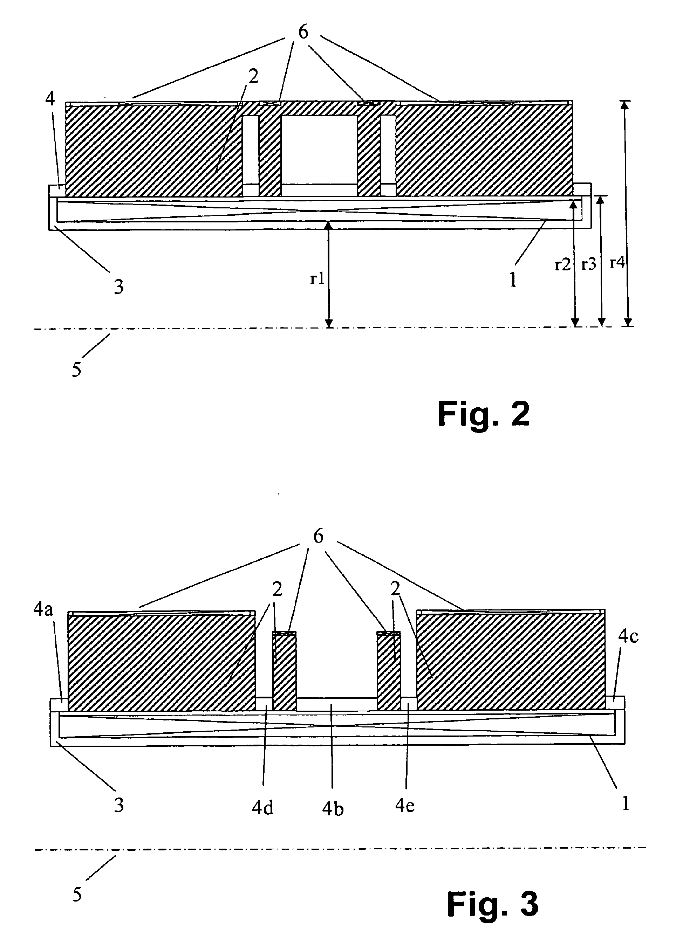

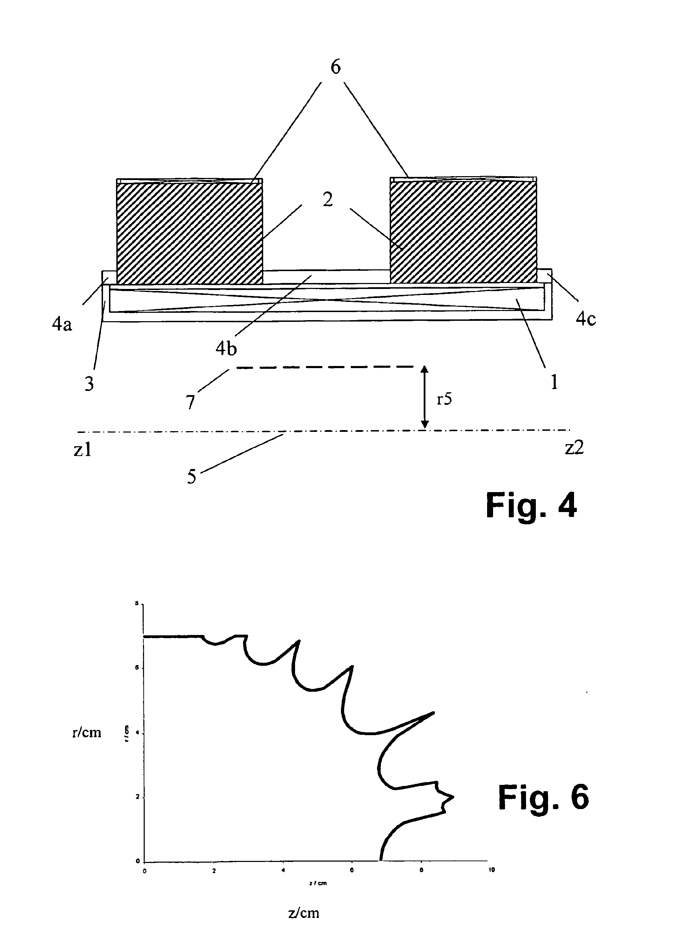

Die Spulen zur Minimierung des Streufelds in der in Fig. 1 gezeigten Anordnung besitzen eine Vielzahl an supraleitenden Windungen, wodurch sich ein nicht unerheblicher Kostenfaktor ergibt. Des Weiteren werden sowohl für die Magnetwicklungen 101, 102, 103 zur Erzeugung des starken Magnetfelds im Untersuchungsvolumen als auch für die zweiten Magnetwicklungen 104, 105 zur Abschirmung des magnetischen Streufelds Tragekörper 106a, 106b benötigt, die das Gewicht und die radiale Ausdehnung der Gesamtanordnung erhöhen. **Fig. 2** zeigt den Aufbau einer erfindungsgemäßen Magnetanordnung, die zur Erzeugung des Hauptmagnetfeldes lediglich eine Solenoidspule 1 umfaßt die sich im Bereich zwischen r1 und r2 erstreckt, und von einem strukturierten Magnetkörper 2 umgeben ist. Die Solenoidspule 1 ist auf einen Spulenkörper aufgewickelt. Der Magnetkörper 2 und die Solenoidspule 1 sind auf Tragekörper **3, 4** montiert und so positioniert, dass sowohl der Magnetkörper 2 als auch die Solenoidspule **1** rotationssymmetrisch zur z-Achse **5** der Magnetanordnung angeordnet sind. Der Magnetkörper 2 wird durch das von der Solenoidspule 1 erzeugte Magnetfeld entgegen der Richtung der magnetischen Induktion im Bereich der z-Achse **5** magnetisiert und verstärkt somit das Gesamtmagnetfeld der Anordnung. Der Magnetkörper 2 ist in einem radialen Bereich zwischen r3 und r4 angeordnet, so dass der Unterschied zwischen r4 und r3 die Dicke des Magnetkörpers 2 definiert. Die Dicke ist so groß zu wählen, dass eine zur Homogenisierung geeignete Strukturierung des Magnetkörpers 2 vorgenommen werden kann. Der Betrag von r3 bzw. r4 ist abhängig von der Größe der Solenoidspule 1, wobei vorzugsweise $r3 < 1,3 \cdot r2$ und $3 \cdot r3 > r4 > L,5 \cdot r3$ zu wählen ist. Durch eine geeignete Strukturierung des Magnefic6rpets 2 in seinem radial inneren Bereich, wie beispielsweise in Fig. 2 gezeigt, lassen sich unerwünschte Störterme der magnetischen Feldstärke ($h_2$, $h_4$, $h_6$, ...) kompensieren. Neben der Homogenisierung des Magnetfelds im Untersuchungsvolumen bewirkt der Magnetkörper 2 zusätzlich eine Abschirmung des von der Magnetanordnung erzeugten Streufeldes. Diese Abschirmung kann durch eine geeignete Wahl des Außendurchmessers r4 des Magnetkörpers 2 beeinflusst werden. Zusätzlich können weitere Wicklungen **6** außerhalb des Magnetkörpers 2 angeordnet sein, die zur Flussführung und damit der Verbesserung der Abschirmung des Streufelds dienen und im Zusammenhang mit den Fig. 6a und 6b näher beschrieben werden.

Wie in **Fig. 3** gezeigt, können statt eines strukturierten Magnetkörpers 2 auch mehrere (hier vier) rotationssymmetrische Magnetkörper 2 um die Solenoidspule 1 angeordnet sein. Die einzelnen Magnetkörper sind über Tragekörper 4a, 4b, 4c, 4d, 4e starr miteinander und mit dem Tragekörper 3 der Solenoidspule 1 verbunden, so dass sich die Magnetkörper 2 nicht unter Einwirkung der magnetischen Kräfte gegeneinander und gegen die Solenoidspule bewegen können.

**Fig. 4** zeigt eine besonders bevorzugte Ausführungsform der Erfindung. Die hier gezeigte Magnetanordnung umfasst eine Solenoidspule 1, zwei Magnetkörper 2 aus Eisen, zwei die Magnetkörper 2 direkt umschließende weitere Wicklungen 6 sowie eine radial innerhalb der Solenoidspule 1 liegenden Feldformvorrichtung 7. Die Magnetkörper 2 sind mit mechanischen Halterungen 4a, 4b, 4c zu einem einzigen mechanischen Teil verbunden. Die mechanischen Halterungen können beispielsweise aus unmagnetischem Stahl bestehen und müssen so ausgelegt sein, dass sie die magnetisch bedingte Anziehungskraft zwischen den Magnetkörpern 2 aufnehmen können. Die Anordnung der Magnetkörper 2 erfolgt symmetrisch zur Mittelebene quer zur z-Achse 5 der Magnetanordnung. Die Magnetkörper 2 sind vorzugsweise als Kreisringe mit rechteckigem Querschnitt ausgebildet und in axial äußeren Bereichen der Magnetanordnung angeordnet, so dass die Grenzflächen der Magnetkörper 2 relativ weit vom Untersuchungsvolumen entfernt sind. Dies ist besonders vorteilhaft, da in diesem Fall die Grenzflächen der Magnetkörper hinsichtlich der Homogenität im Untensuchungsvolumen nahezu keinen störenden Einfluss haben und die Magnetkörper 2 außerdem einen erwünschten positiven Beitrag zu dem Magnetfeldterm $h_2/h_0$ liefern.

Neben der Homogenisierung des Magnetfelds im Untersuchungsvolumen der Magnetanordnung ist die erfindungsgemäße Vorrichtung auch geeignet, das magnetische Streufeld außerhalb der Magnetanordnung zu minimieren. Um eine weitere Reduzierung des Streufelds vorzunehmen, sind bei den Anordnungen aus Fig. 2 bis 4 in einem Bereich $r6 > 0,9 \cdot r4$ radial außerhalb der Magnetkörper 2 weitere supraleitende Wicklungen 6 angeordnet. Die Magnetkörper 2 können dabei als Tragekörper für die Wicklungen 6 dienen, so dass diese direkt auf die Magnetkörper 2 aufgewickelt werden können. Die Wicklungen 6 bestehen aus axial voneinander beabstandeten Teilwicklungen, die jeweils in einer Wickelkammer angeordnet sind. Die Magnetkörper 2 können dazu im radial äußeren Bereich Ausnehmungen aufweisen, in denen die Wickelkammern für die weiteren Wicklungen 6 aufgenommen werden können. Somit werden keine weiteren Tragekörper für die weiteren Wicklungen 6 benötigt. Neben der Reduzierung des magnetischen Streufelds dienen die Wicklungen 6 auch zur Dämpfung von externen Störungen des Magnetfeldes im Arbeitsvolumen.

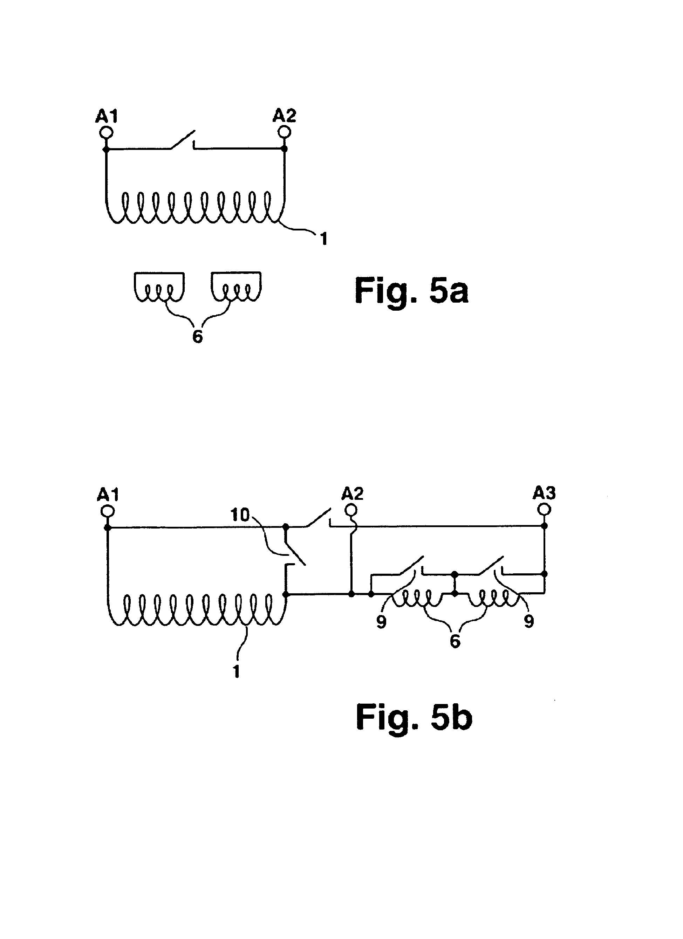

**Fig. 5a** zeigt ein Schaltbild einer Spulenanordnung mit einer Solenoidspule 1 und weiteren Wicklungen 6, die radial außerhalb der Solenoidspule 1 angeordnet sind. Die supraleitenden Spulenkreise sind in diesem Fall elektrisch voneinander getrennt, so dass in den Wicklungen 6 und in der Solenoidspule 1 voneinander unabhängige Ströme fließen. Der Strom durch die Wicklungen 6 kann daher, je nach Auslegung, recht klein sein und dementsprechend die wenigen Wicklungen 6 aus dünnem supraleitendem Draht hergestellt werden. Die Wicklungen 6 werden z.B. vor dem Laden der Solenoidspule 1 kurzgeschlossen. Während des Ladevorgangs der Solenoidspule 1 werden die Magnetkörper 2 aufmagnetisiert und die Wicklungen 6 laden sich induktiv auf. Dies ist vorteilhaft, da beim Laden oder Entladen der Solenoidspule 1 die Magnetisierung der Magnetkörper 2 In Folge von Hysterese und Sättigung des Werkstoffs dem Strom in der Solenoidspule 1 nicht proportional folgt. Infolgedessen wäre das magnetische Streufeld einer Magnetanordnung, die nur aus der Solenoidspule 1 und den Magnetkörpern 2 besteht, nicht minimal. In den kurzgeschlossenen supraleitenden Wicklungen 6 werden jedoch stets genau die Ströme induziert, die den magnetischen Fluss und damit weitgehend das Feldprofil konstant halten. Die Wicklungen 6 wirken dabei wie die Abschirnspulen einer aktiven Abschirmung, werden jedoch massiv durch das magnetisierte Eisen der Magnetkörper 2 unterstützt, das den Hauptanteil der Abschirmung übernimmt. Andererseits übernimmt der Strom durch die Wicklungen 6 diese Aufgabe immer mehr, je weiter das Eisen in die Sättigung gerät.

**Fig. 5b** zeigt ein Schaltbild einer anderen Spulenanordnung, die in verschiedenen Modi betrieben werden kann. Die weiteren Wicklungen 6 sind hierbei mit supraleitenden Schaltern 9 versehen. Die Wicklungen 6 sind mit der Solenoidspule 1 in Serie geschaltet. Dies ermöglicht ein gemeinsames Laden der Solenoidspule 1 und der Wicklungen 6 über die Anschlüsse A1 und A3. In diesem Fall fließt in den Wicklungen 6 derselbe Strom wie in der Solenoidspule 1. Darüber hinaus können die Wicklungen 6 über die Anschlüsse A2 und A3, sowie die Solenoidspule 1 über die Anschlüsse A1 und A2 auch unabhängig voneinander geladen werden. Durch gezieltes Laden der Wicklungen 6 auf einen gewünschten Betriebsstromwert ist eine individuelle Anpassung des magnetischen Streufelds möglich (aktive Abschirmung). Das Prinzip der aktiven Abschirmung ist aus dem Stand der Technik bereits bekannt (US 6,507,259 B2). Üblicherweise werden dazu jedoch Wicklungen 110, 111 (Fig. 1) benötigt, die aus einer großen Anzahl an Lagen mit supraleitendem Material aufgebaut sind. Die Kosten für eine derart abgeschirmte Apparatur sind daher bei konventionellen Magnetanordnungen sehr hoch. Aufgrund des Abschirmeffekts der erfindungsgemäßen Magnetkörper 2 sind jedoch in der Regel für die weiteren Wicklungen 6 lediglich eine bis zehn Lagen mit supraleitendem Material notwendig. Mit der in Fig. 5b gezeigten Schaltung können die Wicklungen 6 beziehungsweise die Solenoidspule 1 durch Schließen der Schalter 9 beziehungsweise des Schalters **10** im kurzgeschlossenen Zustand betrieben werden, so dass das Streufeld minimiert und jeweils ein magnetischer Fluss eingefroren werden kann. Mit einer Spulenanordnung, die gemäß Fig. 5b geschalten ist, können also wahlweise die Wicklungen 6 kurzgeschlossen, extern aufgeladen, oder aber (teilweise) zusammen mit der Solenoidspule 1 aufgeladen werden. Bei der Auslegung des Systems ist zu berücksichtigen, dass die weiteren Wicklungen 6 auch einen Einfluss auf das im Untersuchungsvolumen herrschende Feld haben. Aufgrund der Anordnung der Wicklungen 6 im äußeren Bereich der Magnetanordnung und der geringen Anzahl an Wicklungen ist dieser Einfluss jedoch klein.

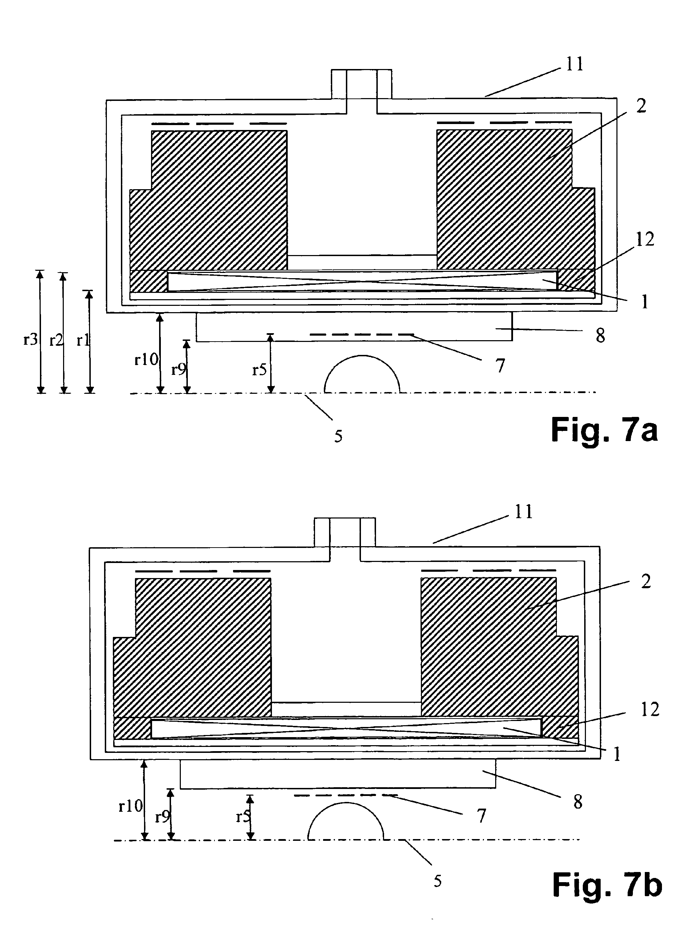

Speziell für den Bereich NMR-Tomographie benötigt man Magnetanordnungen mit großem inneren Spulenradius $r1$, wobei innerhalb von der Solenoidspule 1 ein Gradientensystem **8** angeordnet ist. Während die Solenoidspule 1 und die Magnetkörper 2 innerhalb einer Kryostatanordnung **11** angeordnet sind, befindet sich das Gradientensystem 10 in einem radialen Bereich zwischen $r9$ und $r10$ außerhalb der Kryostatanordnung. Bei der in **Fig. 7a** gezeigten Ausführungsform der erfindungsgemäßen Magnetanordnung ist die Feldformvorrichtung 7 in einem radialen Bereich $r5$ angeordnet, wobei $r9 < r5 < r10$, so dass die Feldformvorrichtung in diesem Fall im Gradientensystem 8 integriert ist. **Fig. 7b** zeigt eine besonders bevorzugte Ausführungsform, bei der die Feldformvorrichtung 7 radial noch näher an der z-Achse angeordnet ist, als das Gradientensystem 8 ($r5 < r9$). Entscheidend für den Einfluss der Feldformvorrichtung 7 auf das im Untersuchungsvolumen herrschende Magnetfeld ist das Verhältnis $r5/r1$ der radialen Anordnung der Feldformvorrichtung 7 zum Radius $r1$ der Solenoidspulen 1. Je keiner das Verhältnis $r5/M$ ist, desto größer ist der Einfluss der Feldformvorrichtung 7 auf das Magnetfeld im Untersuchungsvolumen, so dass für die notwendigen Korrekturen eine Feldformvorrichtung benötigt wird, die aus entsprechend weniger magnetischem Material (im Allgemeinen Eisen) gefertigt sein kann als für eine Feldformvorrichtung die radial weiter außen angeordnet ist. Dies ist insbesondere bei Tomographie-Magneten relevant, da aufgrund des großen Spulenradius für eine Feldformvorrichtung 7 sehr viel magnetisches Material benötigt wird und durch eine achsennahe Anordnung der Feldformvorrichtung Materialkosten eingespart werden können. Bei den in den Fig. 7a und 7b gezeigten Ausführungsformen der erfindungemäß Magnetanordnung sind zu den Magnetkörpern 2 zusätzliche Magnetkörper 12 vorgesehen, die in einem radialen Bereich zwischen $r1$ und $r3$ angeordnet sind, also innerhalb des radialen Bereichs der Solenoidspule, jedoch axial außerhalb der Solenoidspule. Die Solenoidspule kann hierdurch bei gleich bleibendem Magnetfeld im Untersuchungsvolumen kürzer gestaltet werden, wodurch eine Materialersparnis bezüglich des teuren supraleitenden Drahts, aus den die Wicklungen der Solenoidspule gefertigt sind, erreicht werden kann.

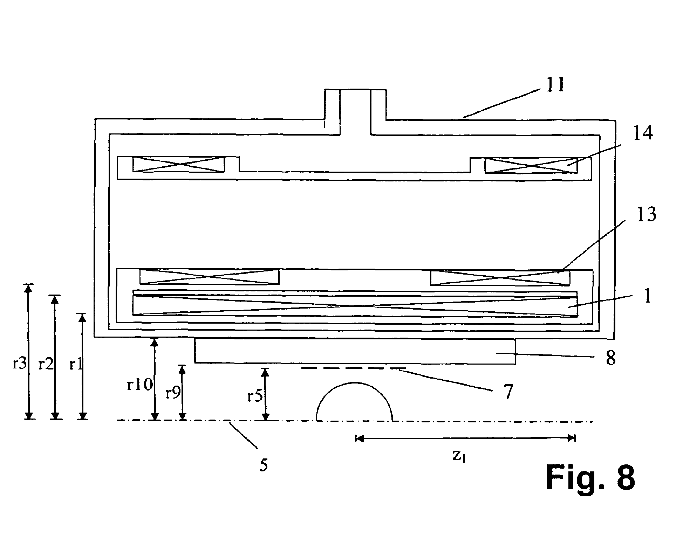

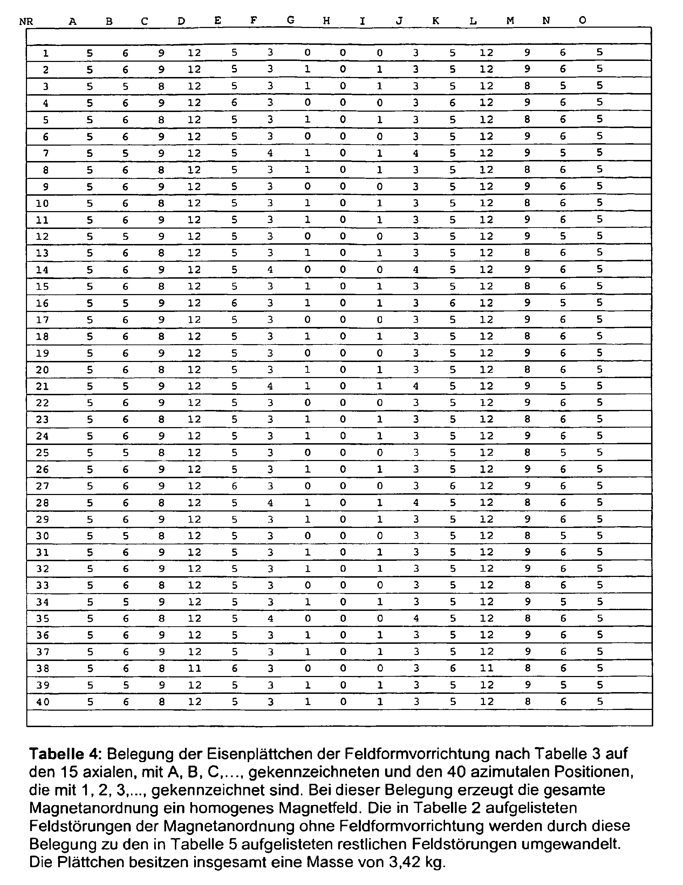

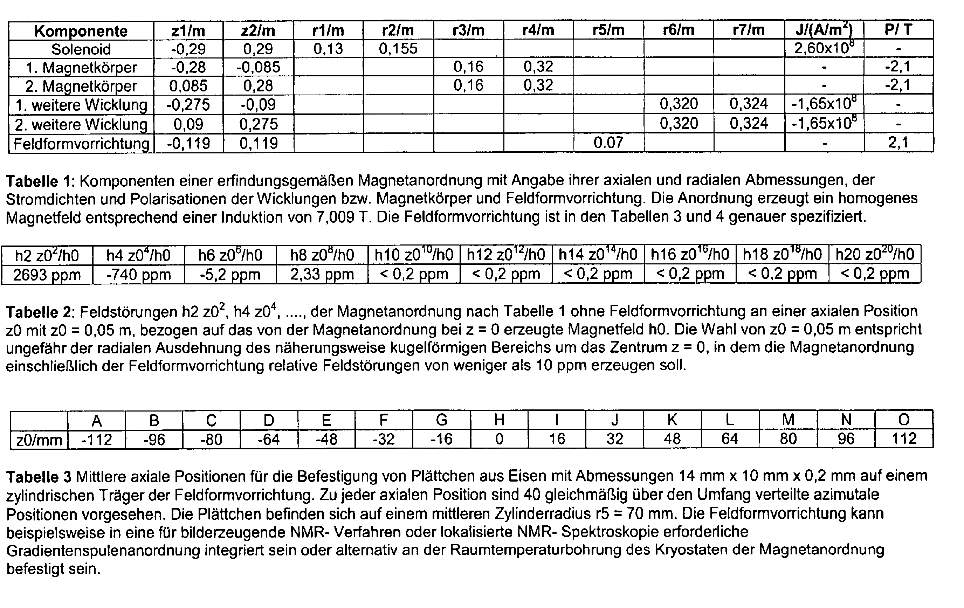

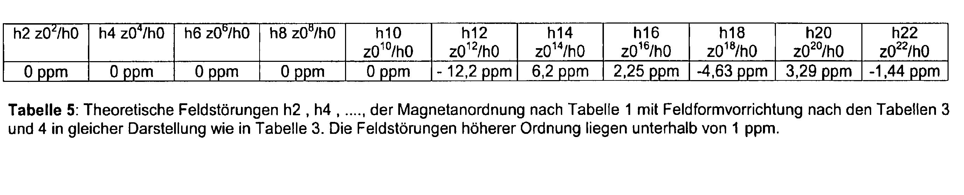

Alternativ zu den Magnetkörpern 2 kann eine Ausführungsform der erfindungsgemäßen Magnetanordnung zusätzlich zur Solenoidspule in einem radialen Bereich außerhalb von $r3$ supraleitende Magnetspulen **13** als Magnetfeld erzeugende Strukturen aufweisen, wie in Fig. 8 dargestellt. Die Aufgabe und die Wirkung der Magnetspulen 13 sind dieselben wie die der Magnetkörper 2, nämlich in Zusammenwirkung der Solenoidspule und der Feldformvorrichtung 7 ein homogenes Magnetfeld innerhalb des Untersuchungsvolumens zu erzeugen.

Die geometrischen Abmessungen und Eigenschaften eines Beispiels der in Fig. 4 gezeigten Ausführungsform der erfindungsgemäßen Magnetanordnung sind in den Tabellen 1-5 dargestellt und spezifiziert. In **Tabelle 1** sind Komponenten einer erfindungsgemäßen Magnetanordnung mit Angabe ihrer axialen und radialen Abmessungen, der Stromdichten und Polarisationen der Wicklungen bzw. Magnet körper und Feldformvorrichtung aufgelistet Die Anordnung erzeugt ein homogenes Magnetfeld entsprechend einer Induktion von 7,009 T.

Die in Fig. 4 gezeigte bevorzugte Ausführungsform der Magnetanordnung weist eine radial innerhalb der Solenoidspule 1 liegenden Feldformvorrichtung 7 auf. Diese erlaubt die Befestigung von kleinen Feldformelementen aus Eisen an vorzugsweise 15 axial und je 40 in Umfangsrichtung verteilten Positionen auf der Oberfläche eines Zylinders mit dem Radius r5, der beispielsweise zu r5 = 0,07 m gewählt werden kann. Die Magnetanordnung erzeugt aufgrund der einfachen Geometrie der Solenoidspule 1 ohne die Feldformvorrichtung 7 theoretisch und praktisch ein inhomogenes und für die Anwendung der Magnetanordnung in NMR-, MRI- oder FTMS- Apparaturen nicht brauchbares Magnetfeld. **Tabelle 2** zeigt Feldstörungen $h_2 z_0^2$, $h_4 z_0^4$,...., der Magnetanordnung nach Tabelle 1 ohne Feldformvorrichtung an einer axialen Position $z_0$ mit $z_0$ = 0,05 m, bezogen auf das von der Magnetanordnung bei z = 0 erzeugte Magnetfeld $h_0$. Die Wahl von = 0,05 m entspricht ungefähr der radialen Ausdehnung des näherungsweise kugelförmigen Bereichs um das Zentrum z = 0, in dem die Magnetanordnung einschließlich der Feldformvorrichtung relative Feldstörungen von weniger als 10 ppm erzeugen soll. Erst die geeignete Verteilung von Feldformelementen, beispielsweise in Form rechteckiger Plättchen aus Eisen, erzeugt ein homogenes Magnetfeld mit relativ großer räumlicher Ausdehnung, das für die genannten Anwendungen in ausgezeichneter Weise geeignet ist. Tabelle 3 zeigt die mittleren axialen Positionen für die Befestigung von Plättchen aus Eisen mit Abmessungen 14 mm x 10 mm x 0,2 mm auf einem zylindrischen Träger der Feldformvorrichtung. Zu jeder axialen Position sind 40 gleichmäßig über den Umfang verteilte azimutale Positionen vorgesehen. Die Plättchen befinden sich auf einem mittleren Zylinderradius r5 = 70 mm. Die Feldformvorrichtung kann beispielsweise in eine für bilderzeugende NMR- Verfahren oder lokalisierte NMR- Spektroskopie erforderliche Gradientenspulenanordnung integriert sein oder alternativ an der Raumtemperaturbohrung des Kryostaten der Magnetanordnung befestigt sein. Die Belegung der Eisenplättchen der Feldformvorrichtung nach Tabelle 3 auf den 15 axialen, mit A, B, C,..., gekennzeichneten und den 40 azimutalen Positionen, die mit 1, 2, 3,..., gekennzeichnet sind, ist in **Tabelle 4** dargestellt. Bei dieser Belegung erzeugt die gesamte Magnetanordnung ein homogenes Magnetfeld. Die in Tabelle 2 aufgelisteten Feldstörungen der Magnetanordnung ohne Feldformvorrichtung werden durch diese Belegung zu den in Tabelle 5 aufgelisteten restlichen Feldstörungen umgewandelt. Die Plättchen besitzen insgesamt eine Masse von 3,42 kg.

In **Fig. 6** ist die Konturlinie r(z) konstanter relativer Abweichung der Magnetfeldstärke von +/- 5 ppm bezogen auf das Feld im Zentrum einer Magnetanordnung nach den Tabellen 1-5 in einem Quadranten der Bohrung dargestellt. Innerhalb der Konturlinie ist die relative Abweichung der Magnetfeldstärke kleiner als +/- 5 ppm. In dem Bereich z < 3 cm ist dieser Bereich durch die Feldformvorrichtung mit dem relativ klein gewählten Radius r5 = 7 cm begrenzt. Solche Feldformvorrichtungen 7 sind von herkömmlichen Magnetanordnungen für MRI-Apparaturen bekannt und dienen dabei der Korrektur von Inhomogenitäten des Magnetfeldes infolge von geometrischen Abweichungen der Wicklungen der Magnetapparaturen von den theoretisch idealen Anordnungen aufgrund praktisch unvermeidlicher mechanischer Toleranzen der verwendeten Spulenkörper und des verwendeten Supraleiterdrahtes (DE 101 040 54). Die Berechnungsmethoden geeigneter Verteilungen von Feldformelementen zur Korrektur von ursprünglichen Inhomogenitäten des Magnetfelds, wie man sie aus Messungen ermitteln kann, sind dem Fachmann für die Konstruktion herkömmlicher Magnetapparaturen für MRI- Apparaturen bekannt. Es ist jedoch erstaunlich zu sehen, mit welch geringen Mengen an Feldformelementen die theoretisch erwarteten Inhomogenitäten der erfindungsgemäßen Magnetanordnungen ohne die Berücksichtigung der Feldformvorrichtung 7 nach dem Ausführungsbeispiel kompensiert werden können. Um die Menge an Feldformelementen in der Feldformvorrichtung gering zu halten und gleichzeitig große Arbeitsvolumina mit hoher Homogenität des Magnetfelds zu erhalten, ist es vorteilhaft, wenn die Magnetanordnung ohne Berücksichtigung der Feldformvorrichtung 7 einen negativen Magnetfeldterm h4/h0 und einen positiven Magnetfeldterm h2/h0 erzeugt. Diese Magnetfeldterme lassen sich durch die Wahl der axialen Begrenzungen z1 und z2 der Solenoidspule 1 sowie der beiden Magnetkörper 2 sowie des inneren Radius r3 der Magnetkörper 2 in der genannten Weise einstellen. Die entsprechenden Methoden sind dem Fachmann für die Konstruktion herkömmlicher Magnetanordnungen bekannt. Durch das Miteinbeziehen der Feldformvorrichtung in die Auslegung des Systems ergibt sich eine verkürzte Bauform der Magnetanordnung. Eine derartige Feldformvorrichtung 7 kann auch aus ferromagnetischen Folien oder Blechen aufgebaut sein, die zur Homogenisierung des Magnetfelds im Untersuchungsvolumen geeignete Ausstanzungen aufweisen, wie dies bereits aus der US 2002/0,140,535 A1 bekannt ist. Als besonders vorteilhaft erweist es sich, wenn der mit (-1) multiplizierte Quotient aus den Magnetfeldtermen $h_2$ und $h_4$ mindestens gleich dem haben Quadrat des Radius r5 der Feldformvorrichtung ist. Dann lassen sich in besonders großen Untersuchungsvolumina Magnetfelder großer Homogenität mit besonders kleinen Mengen an Feldformelementen in der Feldformvorrichtung erzeugen. Bei dem in den Tabellen 1-5 beschriebenen Ausführungsbeispiel beträgt der Quotient aus den Magnetfeldermen $(-h_2/h_4)$ etwa 91 $cm^2$ , ist also deutlich größer als 0,5 $r5^2$ = 24.5 $cm^2$. Wie Tab. 5 zeigt, beträgt Durchmesser des homogenen Volumens mit einer relativen Feldstörung von weniger als 10 ppm etwa 14 cm. Die benötigte Menge von Feldformelementen aus Eisen nach Tabelle 5 beträgt 3,42 kg.

Die vorliegende Erfindung ermöglicht eine kompakte und kostengünstige Bauweise einer Magnetanordnung zur Messung magnetischer Resonanz, mit Hilfe derer, insbesondere bei der Erzeugung hoher Magnetfelder (B > 6 T), die Homogenität des Magnetfelds in einem Untersuchungsvolumen und gleichzeitig die Zuverlässigkeit der Magnetanordnung verbessert werden kann.

## Bezugzeichenliste

| | |
|---|---|
| 1 | Solenoidspule |
| 2 | Magnetkörper |
| 3 | Tragekörper |
| 4 | Tragekörper |
| 5 | z-Achse |
| 6 | weitere Wicklungen |
| 7 | Feldformvorrichtung |
| 8 | Gradientensystem |
| 9 | supraleitenden Schalter |
| 10 | Schalter |
| 11 | Kryostatanordnung |
| 12 | zusätzliche Magnetkörper |
| 13 | supraleitende Magnetspulen |
| 14 | Abschirmspulensystem |

## Patentansprüche

1. Koaxiale Magnetanordnung zur Erzeugung eines längs einer z-Achse (5) verlaufenden Magnetfelds in einem Untersuchungsvolumen um z = 0, das geeignet ist zur Messung magnetischer Resonanz, mit mindestens einer oder mit mehreren radial ineinander geschachtelten supraleitenden Solenoidspulen (1), die rotationssymmetrisch zur z-Achse (5) angeordnet sind und eine maximale axiale Ausdehnung 2. $z_1$ aufweisen, wobei die Solenoidspulen (1) auf Formkörpern aufgewickelt sind, die keine axialen Notches aufweisen, wobei die Windungen der mindestens einen Solenoidspule (1) in einem radialen Bereich um die z-Achse (5) der Magnetanordnung zwischen r1 und r2 mit r1 < r2 angeordnet und von weiteren Magnetfeld erzeugenden Strukturen (2, 12, 13) umgeben sind, die rotationssymmetrisch bezüglich der z-Achse (5) angeordnet sind, und die sich ausgehend von einem Radius r3, mit r3 > r2, radial nach außen erstrecken, wobei die Solenoidspule (1) und die weiteren rotationssymmetrischen Magnetfeld erzeugenden Strukturen (2, 12, 13) im Untersuchungsvolumen konstruktionsbedingt ein Magnetfeld erzeugen, das mindestens einen inhomogenen Anteil $h_n z^n$ mit n ≥ 2 aufweist, dessen Beitrag zur Gesamtfeldstärke auf der z-Achse (5) um z = 0 mit der n-ten Potenz von z variiert, und wobei eine Feldformvorrichtung (7) aus magnetischem Material in einem radialen Bereich r5 < r1 vorgesehen ist, die den mindestens einen inhomogenen Anteil $h_n z^n$ kompensiert,
   **dadurch gekennzeichnet,**
   **dass** um das Untersuchungsvolumen ein Gradientenspulensystem (8) in einem radialen Bereich zwischen r9 und r10 mit r10 > r9 vorgesehen ist,
   **dass** r5 < r10,
   **dass** $\dfrac{r5}{r1} < 0{,}7$,
   **dass** r5 ≥ 80 mm,
   **dass** das Aspektverhältnis $\dfrac{z1}{r1} < 5$,
   und **dass** die mindestens eine Solenoidspule (1), die Feldformvorrichtung (7) und die weiteren Magnetfeld erzeugenden Strukturen (2, 12, 13) zusammen ein homogenes Feld im Untersuchungsvolumen erzeugen.

2. Magnetanordnung nach Anspruch 1, **dadurch gekennzeichnet, dass** die Feldformvorrichtung (7) in einem radialen Bereich r5 < r9 angeordnet ist.

3. Magnetanordnung nach einem der vorhergehenden Ansprüche, **dadurch gekennzeichnet, dass** die mindestens eine Solenoidspule (1), die Magnetfeld erzeugenden Strukturen (2, 12, 13) und die Feldformvorrichtung (7) im Betrieb im Untersuchungsvolumen zusammen ein Magnetfeldprofil erzeugen, dessen z-Komponente in einer Reihenentwicklung entlang der z-Achse (5) um das Symmetriezentrum des Untersuchungsvolumens
$h = h_0 + h_2 z^2 + h_4 z^4 + ... + h_{2n} z^{2n}$ mit positivem Magnetfeldterm $h_0$ beträgt,
und dass der gemeinsame Beitrag von der mindestens einen Solenoidspule (1) und den Magnetfeld erzeugenden Strukturen (2, 12, 13) zum Magnetfeldterm der 2. Ordnung positiv und zum Magnetfeldterm der 4. Ordnung negativ ist, während der Beitrag der Feldformvorrichtung (7) zum Magnetfeldterm der 2. Ordnung negativ und zum Magnetfeldterm der 4. Ordnung positiv ist.

4. Magnetanordnung nach Anspruch 3, **dadurch gekennzeichnet, dass** zusätzliche Magnetkörper (12) an den axialen Enden der Solenoidspule in einem radialen Bereich zwischen r1 und r3 vorgesehen sind

5. Magnetanordnung nach Anspruch 4, **dadurch gekennzeichnet, dass** die Magnetkörper (2) und die zusätzlichen Magnetkörper (12) zusammen einstückig ausgebildet sind.

6. Magnetanordnung nach einem der Ansprüche 1 bis 3, **dadurch gekennzeichnet, dass** die weiteren Magnetfeld erzeugenden Strukturen supraleitende Magnetspulen (13) umfassen.

7. Magnetanordnung nach Anspruch 6 **dadurch gekennzeichnet, dass** die Magnetfeld erzeugende Strukturen mindestens 2, vorzugsweise genau 2, axial voneinander beabstandete Magnetspulen (13) umfassen.

8. Magnetanordnung nach einem der Ansprüche 6 oder 7, **dadurch gekennzeichnet, dass** die mindestens eine Solenoidspule (1) und die weiteren Magnetfeld erzeugenden Strukturen (13) von einem supraleitenden aktiven Abschirmspulensystem (14) umgeben sind.

9. Magnetanordnung nach einem der vorhergehenden Ansprüche, **dadurch gekennzeichnet, dass** $\frac{r5}{r1} < 0{,}52$ ist.

10. NMR-Apparatur, MRI-Apparatur oder ICR-Apparatur, **dadurch gekennzeichnet, dass** die Apparatur eine Magnetanordnung nach einem der vorhergehenden Ansprüche umfasst.

**Claims**

1. Coaxial magnet configuration for generating a magnetic field, extending along a z-axis (5), in a volume under investigation about z=0, which is suited for measuring the magnetic resonance, with at least one or more radially nested superconducting solenoid coils (1) that are disposed rotationally symmetrical with respect to the z-axis (5) and have a maximum axial extension of $2.z_1$, wherein the solenoid coils (1) are wound onto shaped bodies that have no axial notches, wherein the windings of the at least one solenoid coil (1) are arranged in a radial area about the z-axis (5) of the magnet configuration between r1 and r2 with r1 <r2, and are surrounded by further structures (2, 12, 13) that generate a magnetic field, are disposed rotationally symmetrical with respect to the z-axis (5), and extend, starting from a radius r3 with r3>r2 in a radial outward direction, wherein the solenoid coil (1) and the other rotationally symmetrical structures (2, 12, 13) generating a magnetic field generate, due to construction, a magnetic field in the volume under investigation, which has at least one inhomogeneous portion $h_n z^n$ with n≥2, whose contribution to the overall field strength on the z-axis (5) about z=0 varies with the nth power of z, and wherein a field forming device (7) of magnetic material is provided in a radial area r5<r1, which compensates for the at least one inhomogeneous portion $h_n z^n$, **characterized in that** a gradient coil system (8) is provided around the volume under investigation in a radial area between r9 and r10 with r10>r9,
**in that** r5 < r10,

**in that** $\frac{r5}{r1} < 0.7$,

**in that** r5 ≥ 80 mm,

**in that** the aspect ratio is $\frac{z1}{r1} < 5$,

and **in that** the at least one solenoid coil (1), the field shaping device (7) and the further structures (2, 12, 13) that generate a magnetic field together generate a homogeneous field in the volume under investigation.

2. Magnet configuration according to claim 1, **characterized in that** the field forming device (7) is disposed in a radial area r5<r9.

3. Magnet configuration according to any one of the preceding claims, **characterized in that** the at least one solenoid coil (1), the structures (2, 12, 13) generating the magnetic field, and the field forming device (7) together generate a magnetic field profile in the volume under investigation during operation, whose z component in a series expansion along the z-axis (5) about the symmetry center of the volume under investigation is $h = h_0 + h_2 Z^2 + h_4 Z^4 + ... + h_{2n} z^{2n}$ with positive magnetic field term $h_0$,
and that the common contribution of the at least one solenoid coil (1) and the structures (2, 12, 13) generating the magnetic field, to the magnetic field term of 2nd order is positive and is negative to the magnetic field term of 4th order, while the contribution of the field forming device (7) to the magnetic field term of 2nd order is negative and is positive to the magnetic field term of 4th order.

4. Magnet configuration according to claim 3, **characterized in that** additional magnet bodies (12) are provided at the axial ends of the solenoid coil in a radial area between r1 and r3.

5. Magnet configuration according to claim 4, **characterized in that** the magnet bodies (2) and the additional magnet bodies (12) are formed together in one piece.

6. Magnet configuration according to any one of the claims 1 through 3, **characterized in that** the further structures that generate a magnetic field comprise superconducting magnet coils (13).

7. Magnet configuration according to claim 6, **characterized in that** the structures generating the magnetic field comprise at least two, preferably exactly two, magnet coils (13) that are disposed at an axial separation from each other.

8. Magnet configuration according to any one of the claims 6 or 7, **characterized in that** the at least one solenoid coil (1) and the further structures (13) that generate a magnetic field are surrounded by a superconducting active shielding coil system (14).

9. Magnet configuration according to any one of the preceding claims,

   **characterized in that** $\dfrac{r5}{r1} < 0.52$ .

10. NMR apparatus, MRI apparatus or ICR apparatus, **characterized in that** the apparatus comprises a magnet configuration according to any one of the preceding claims.

**Revendications**

1. Dispositif magnétique coaxial pour générer un champ magnétique s'étendant suivant un axe z (5) dans un volume d'analyse autour de z = 0, qui est apte à la mesure de résonance magnétique, avec au moins une ou avec plusieurs bobines solénoïdes (1) supraconductrices emboîtées radialement les unes dans les autres qui sont disposées selon une symétrie de révolution par rapport à l'axe z (5) et présentent une extension axiale maximale $2 \cdot z_1$, les bobines solénoïdes (1) étant enroulées sur des corps moulés qui ne présentent pas d'encoches axiales, les spires de ladite au moins une bobine solénoïde (1) étant disposées dans une région radiale autour de l'axe z (5) du dispositif magnétique comprise entre r1 et r2 avec r1 < r2 et étant entourées d'autres structures génératrices de champ magnétique (2, 12, 13) qui sont disposées selon une symétrie de révolution par rapport à l'axe z (5) et qui s'étendent radialement vers l'extérieur en partant d'un rayon r3, avec r3 > r2, la bobine solénoïde (1) et les autres structures génératrices de champ magnétique (2, 12, 13) à symétrie de révolution générant par construction dans le volume d'analyse un champ magnétique qui présente au moins une composante inhomogène $h_n z^n$ avec n ≥ 2, dont la contribution à l'intensité de champ totale sur l'axe z (5) autour de z = 0 varie avec la $n^{\text{ième}}$ puissance de z, et un dispositif conformateur de champ (7) en matériau magnétique étant prévu dans une région radiale r5 < r1, lequel compense au moins une composante inhomogène $h_n z^n$,

**caractérisé en ce**

**qu'**il est prévu autour du volume d'analyse un système de bobines de gradient (8) dans une région radiale comprise entre r9 et r10 avec r10 > r9,

**que** r5 < r 10,

**que** $\dfrac{r5}{r1} < 0{,}7,$

**que** r5 $\geq$ 80 mm,

**que** le rapport d'aspect $\dfrac{z1}{r1} < 5,$

et **que** ladite au moins une bobine solénoïde (1), le dispositif conformateur de champ (7) et les autres structures génératrices de champ magnétique (2, 12, 13) génèrent ensemble un champ homogène dans le volume d'analyse.

2. Dispositif magnétique selon la revendication 1, **caractérisé en ce que** le dispositif conformateur de champ (7) est disposé dans une région radiale r5 < r9.

3. Dispositif magnétique selon l'une des revendications précédentes, **caractérisé en ce que** ladite au moins une bobine solénoïde (1), les structures génératrices de champ magnétique (2, 12, 13) et le dispositif conformateur de champ (7) génèrent ensemble en fonctionnement dans le volume d'analyse un profil de champ magnétique dont la composante z dans un développement en série le long de l'axe z (5) autour du centre de symétrie du volume d'analyse est
h = $h_0$ + $h_2 z^2$ + $h_4 z^4$ + ... + $h_{2n} z^{2n}$ avec un terme de champ magnétique $h_0$ positif,
et que la contribution commune de ladite au moins une bobine solénoïde (1) et des structures génératrices de champ magnétique (2, 12, 13) au terme de champ magnétique du 2ème ordre est positive et au terme de champ magnétique du 4ème ordre négative, tandis que la contribution du dispositif conformateur de champ (7) au terme de champ magnétique du 2ème ordre est négative et au terme de champ magnétique du 4ème ordre positive.

4. Dispositif magnétique selon la revendication 3, **caractérisé en ce que** des corps magnétiques supplémentaires (12) sont prévus aux extrémités axiales de la bobine solénoïde dans une région radiale comprise entre r1 et r3.

5. Dispositif magnétique selon la revendication 4, **caractérisé en ce que** les corps magnétiques (2) et les corps magnétiques supplémentaires (12) sont réalisés ensemble d'une seule pièce.

6. Dispositif magnétique selon l'une des revendications 1 à 3, **caractérisé en ce que** les autres structures génératrices de champ magnétique comprennent des solénoïdes supraconducteurs (13).

7. Dispositif magnétique selon la revendication 6, **caractérisé en ce que** les structures génératrices de champ magnétique comprennent au moins 2, de préférence exactement 2, solénoïdes (13) distants l'une de l'autre axialement.

8. Dispositif magnétique selon l'une des revendications 6 à 7, **caractérisé en ce que** ladite au moins une bobine solénoïde (1) et les autres structures génératrices de champ magnétique (13) sont entourées d'un système de bobines de blindage actif supraconductrices (14).

9. Dispositif magnétique selon l'une des revendications précédentes, **caractérisé en ce que** $\dfrac{r5}{r1} < 0{,}52.$

10. Appareillage de RMN, appareillage d'IRM ou appareillage de RCI **caractérisé en ce que** l'appareillage comprend un dispositif magnétique selon l'une des revendications précédentes.

**Fig. 1**

**Fig. 2**

**Fig. 3**

**Fig. 4**

r/cm

z/cm

**Fig. 6**

A1                   A2

1

6

**Fig. 5a**

A1           10             A2               A3

9        6        9

1

**Fig. 5b**

**Fig. 7a**

**Fig. 7b**

**Fig. 8**

| NR | A | B | C | D | E | F | G | H | I | J | K | L | M | N | O |
|----|---|---|---|---|---|---|---|---|---|---|---|---|---|---|---|
| 1 | 5 | 6 | 9 | 12 | 5 | 3 | 0 | 0 | 0 | 3 | 5 | 12 | 9 | 6 | 5 |
| 2 | 5 | 6 | 9 | 12 | 5 | 3 | 1 | 0 | 1 | 3 | 5 | 12 | 9 | 6 | 5 |
| 3 | 5 | 5 | 8 | 12 | 5 | 3 | 1 | 0 | 1 | 3 | 5 | 12 | 8 | 5 | 5 |
| 4 | 5 | 6 | 9 | 12 | 6 | 3 | 0 | 0 | 0 | 3 | 6 | 12 | 9 | 6 | 5 |
| 5 | 5 | 6 | 8 | 12 | 5 | 3 | 1 | 0 | 1 | 3 | 5 | 12 | 8 | 6 | 5 |
| 6 | 5 | 6 | 9 | 12 | 5 | 3 | 0 | 0 | 0 | 3 | 5 | 12 | 9 | 6 | 5 |
| 7 | 5 | 5 | 9 | 12 | 5 | 4 | 1 | 0 | 1 | 4 | 5 | 12 | 9 | 5 | 5 |
| 8 | 5 | 6 | 8 | 12 | 5 | 3 | 1 | 0 | 1 | 3 | 5 | 12 | 8 | 6 | 5 |
| 9 | 5 | 6 | 9 | 12 | 5 | 3 | 0 | 0 | 0 | 3 | 5 | 12 | 9 | 6 | 5 |
| 10 | 5 | 6 | 8 | 12 | 5 | 3 | 1 | 0 | 1 | 3 | 5 | 12 | 8 | 6 | 5 |
| 11 | 5 | 6 | 9 | 12 | 5 | 3 | 1 | 0 | 1 | 3 | 5 | 12 | 9 | 6 | 5 |
| 12 | 5 | 5 | 9 | 12 | 5 | 3 | 0 | 0 | 0 | 3 | 5 | 12 | 9 | 5 | 5 |
| 13 | 5 | 6 | 8 | 12 | 5 | 3 | 1 | 0 | 1 | 3 | 5 | 12 | 8 | 6 | 5 |
| 14 | 5 | 6 | 9 | 12 | 5 | 4 | 0 | 0 | 0 | 4 | 5 | 12 | 9 | 6 | 5 |
| 15 | 5 | 6 | 8 | 12 | 5 | 3 | 1 | 0 | 1 | 3 | 5 | 12 | 8 | 6 | 5 |
| 16 | 5 | 5 | 9 | 12 | 6 | 3 | 1 | 0 | 1 | 3 | 6 | 12 | 9 | 5 | 5 |
| 17 | 5 | 6 | 9 | 12 | 5 | 3 | 0 | 0 | 0 | 3 | 5 | 12 | 9 | 6 | 5 |
| 18 | 5 | 6 | 8 | 12 | 5 | 3 | 1 | 0 | 1 | 3 | 5 | 12 | 8 | 6 | 5 |
| 19 | 5 | 6 | 9 | 12 | 5 | 3 | 0 | 0 | 0 | 3 | 5 | 12 | 9 | 6 | 5 |
| 20 | 5 | 6 | 8 | 12 | 5 | 3 | 1 | 0 | 1 | 3 | 5 | 12 | 8 | 6 | 5 |
| 21 | 5 | 5 | 9 | 12 | 5 | 4 | 1 | 0 | 1 | 4 | 5 | 12 | 9 | 5 | 5 |
| 22 | 5 | 6 | 9 | 12 | 5 | 3 | 0 | 0 | 0 | 3 | 5 | 12 | 9 | 6 | 5 |
| 23 | 5 | 6 | 8 | 12 | 5 | 3 | 1 | 0 | 1 | 3 | 5 | 12 | 8 | 6 | 5 |
| 24 | 5 | 6 | 9 | 12 | 5 | 3 | 1 | 0 | 1 | 3 | 5 | 12 | 9 | 6 | 5 |
| 25 | 5 | 5 | 8 | 12 | 5 | 3 | 0 | 0 | 0 | 3 | 5 | 12 | 8 | 5 | 5 |
| 26 | 5 | 6 | 9 | 12 | 5 | 3 | 1 | 0 | 1 | 3 | 5 | 12 | 9 | 6 | 5 |
| 27 | 5 | 6 | 9 | 12 | 6 | 3 | 0 | 0 | 0 | 3 | 6 | 12 | 9 | 6 | 5 |
| 28 | 5 | 6 | 8 | 12 | 5 | 4 | 1 | 0 | 1 | 4 | 5 | 12 | 8 | 6 | 5 |
| 29 | 5 | 6 | 9 | 12 | 5 | 3 | 1 | 0 | 1 | 3 | 5 | 12 | 9 | 6 | 5 |
| 30 | 5 | 5 | 8 | 12 | 5 | 3 | 0 | 0 | 0 | 3 | 5 | 12 | 8 | 5 | 5 |
| 31 | 5 | 6 | 9 | 12 | 5 | 3 | 1 | 0 | 1 | 3 | 5 | 12 | 9 | 6 | 5 |
| 32 | 5 | 6 | 9 | 12 | 5 | 3 | 1 | 0 | 1 | 3 | 5 | 12 | 9 | 6 | 5 |
| 33 | 5 | 6 | 8 | 12 | 5 | 3 | 0 | 0 | 0 | 3 | 5 | 12 | 8 | 6 | 5 |
| 34 | 5 | 5 | 9 | 12 | 5 | 3 | 1 | 0 | 1 | 3 | 5 | 12 | 9 | 5 | 5 |
| 35 | 5 | 6 | 8 | 12 | 5 | 4 | 0 | 0 | 0 | 4 | 5 | 12 | 8 | 6 | 5 |
| 36 | 5 | 6 | 9 | 12 | 5 | 3 | 1 | 0 | 1 | 3 | 5 | 12 | 9 | 6 | 5 |
| 37 | 5 | 6 | 9 | 12 | 5 | 3 | 1 | 0 | 1 | 3 | 5 | 12 | 9 | 6 | 5 |
| 38 | 5 | 6 | 8 | 11 | 6 | 3 | 0 | 0 | 0 | 3 | 6 | 11 | 8 | 6 | 5 |
| 39 | 5 | 5 | 9 | 12 | 5 | 3 | 1 | 0 | 1 | 3 | 5 | 12 | 9 | 5 | 5 |
| 40 | 5 | 6 | 8 | 12 | 5 | 3 | 1 | 0 | 1 | 3 | 5 | 12 | 8 | 6 | 5 |

**Tabelle 4**: Belegung der Eisenplättchen der Feldformvorrichtung nach Tabelle 3 auf den 15 axialen, mit A, B, C,..., gekennzeichneten und den 40 azimutalen Positionen, die mit 1, 2, 3,..., gekennzeichnet sind. Bei dieser Belegung erzeugt die gesamte Magnetanordnung ein homogenes Magnetfeld. Die in Tabelle 2 aufgelisteten Feldstörungen der Magnetanordnung ohne Feldformvorrichtung werden durch diese Belegung zu den in Tabelle 5 aufgelisteten restlichen Feldstörungen umgewandelt. Die Plättchen besitzen insgesamt eine Masse von 3,42 kg.

| Komponente | z1/m | z2/m | r1/m | r2/m | r3/m | r4/m | r5/m | r6/m | r7/m | $J/(A/m^2)$ | P/ T |
|---|---|---|---|---|---|---|---|---|---|---|---|
| Solenoid | -0,29 | 0,29 | 0,13 | 0,155 | | | | | | $2{,}60{\times}10^8$ | - |
| 1. Magnetkörper | -0,28 | -0,085 | | | 0,16 | 0,32 | | | | - | -2,1 |
| 2. Magnetkörper | 0,085 | 0,28 | | | 0,16 | 0,32 | | | | - | -2,1 |
| 1. weitere Wicklung | -0,275 | -0,09 | | | | | | 0,320 | 0,324 | $-1{,}65{\times}10^8$ | - |
| 2. weitere Wicklung | 0,09 | 0,275 | | | | | | 0,320 | 0,324 | $-1{,}65{\times}10^8$ | - |
| Feldformvorrichtung | -0,119 | 0,119 | | | | | 0.07 | | | - | 2,1 |

**Tabelle 1**: Komponenten einer erfindungsgemäßen Magnetanordnung mit Angabe ihrer axialen und radialen Abmessungen, der Stromdichten und Polarisationen der Wicklungen bzw. Magnetkörper und Feldformvorrichtung. Die Anordnung erzeugt ein homogenes Magnetfeld entsprechend einer Induktion von 7,009 T. Die Feldformvorrichtung ist in den Tabellen 3 und 4 genauer spezifiziert.

| $h2\ z0^2/h0$ | $h4\ z0^4/h0$ | $h6\ z0^6/h0$ | $h8\ z0^8/h0$ | $h10\ z0^{10}/h0$ | $h12\ z0^{12}/h0$ | $h14\ z0^{14}/h0$ | $h16\ z0^{16}/h0$ | $h18\ z0^{18}/h0$ | $h20\ z0^{20}/h0$ |
|---|---|---|---|---|---|---|---|---|---|
| 2693 ppm | -740 ppm | -5,2 ppm | 2,33 ppm | < 0,2 ppm | < 0,2 ppm | < 0,2 ppm | < 0,2 ppm | < 0,2 ppm | < 0,2 ppm |

**Tabelle 2**: Feldstörungen $h2\ z0^2$, $h4\ z0^4$, ...., der Magnetanordnung nach Tabelle 1 ohne Feldformvorrichtung an einer axialen Position z0 mit z0 = 0,05 m, bezogen auf das von der Magnetanordnung bei z = 0 erzeugte Magnetfeld h0. Die Wahl von z0 = 0,05 m entspricht ungefähr der radialen Ausdehnung des näherungsweise kugelförmigen Bereichs um das Zentrum z = 0, in dem die Magnetanordnung einschließlich der Feldformvorrichtung relative Feldstörungen von weniger als 10 ppm erzeugen soll.

| | A | B | C | D | E | F | G | H | I | J | K | L | M | N | O |
|---|---|---|---|---|---|---|---|---|---|---|---|---|---|---|---|
| z0/mm | -112 | -96 | -80 | -64 | -48 | -32 | -16 | 0 | 16 | 32 | 48 | 64 | 80 | 96 | 112 |

**Tabelle 3** Mittlere axiale Positionen für die Befestigung von Plättchen aus Eisen mit Abmessungen 14 mm x 10 mm x 0,2 mm auf einem zylindrischen Träger der Feldformvorrichtung. Zu jeder axialen Position sind 40 gleichmäßig über den Umfang verteilte azimutale Positionen vorgesehen. Die Plättchen befinden sich auf einem mittleren Zylinderradius r5 = 70 mm. Die Feldformvorrichtung kann beispielsweise in eine für bilderzeugende NMR- Verfahren oder lokalisierte NMR- Spektroskopie erforderliche Gradientenspulenanordnung integriert sein oder alternativ an der Raumtemperaturbohrung des Kryostaten der Magnetanordnung befestigt sein.

| h2 $z0^2$/h0 | h4 $z0^4$/h0 | h6 $z0^6$/h0 | h8 $z0^8$/h0 | h10 $z0^{10}$/h0 | h12 $z0^{12}$/h0 | h14 $z0^{14}$/h0 | h16 $z0^{16}$/h0 | h18 $z0^{18}$/h0 | h20 $z0^{20}$/h0 | h22 $z0^{22}$/h0 |
|---|---|---|---|---|---|---|---|---|---|---|
| 0 ppm | 0 ppm | 0 ppm | 0 ppm | 0 ppm | - 12,2 ppm | 6,2 ppm | 2,25 ppm | -4,63 ppm | 3,29 ppm | -1,44 ppm |

**Tabelle 5**: Theoretische Feldstörungen h2 , h4 , ...., der Magnetanordnung nach Tabelle 1 mit Feldformvorrichtung nach den Tabellen 3 und 4 in gleicher Darstellung wie in Tabelle 3. Die Feldstörungen höherer Ordnung liegen unterhalb von 1 ppm.

EP 1 564 562 B1

EP 1 564 562 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 10104054
- US 2002140427 A
- EP 1229340 A
- US 6507259 B1
- US 4590428 A
- US 6507259 B2
- US 20020140535 A1